# DEMANDE DE BREVET EUROPEEN

(11) **EP 2 237 423 A1**
(43) Date de publication de la demande: **06.10.2010**
(21) Numéro de dépôt: 09156065.6
(22) Date de dépôt: 24.03.2009
(51) Int. Cl.: H03L 7/22, H03L 7/099, H03L 7/23

(54) **Synthétiseur de fréquence**

(71) Demandeur: CSEM Centre Suisse d'Electronique et de Microtechnique SA - Recherche et Développement, 2002 Neuchâtel (CH)
(72) Inventeur: Ruffieux, David, 1789, Lugnorre (CH)
(74) Mandataire: GLN

(57) **Abrégé**

La présente invention concerne un synthétiseur de fréquence comprenant :
- un premier oscillateur commandé (1) par un premier dispositif d'asservissement, le premier oscillateur présentant un facteur de qualité élevé, supérieur à 300 et produisant un premier signal d'horloge (2) RF de fréquence fixe,
- le premier dispositif d'asservissement (30), asservissant la fréquence du premier oscillateur commandé (1) à partir d'une première fréquence de référence,
- un second oscillateur commandé (3) par un second dispositif d'asservissement, et produisant un second signal d'horloge (4),
- le second dispositif d'asservissement (31), asservissant la fréquence du second oscillateur commandé (3) à partir d'une seconde fréquence de référence, et
- un diviseur entier de fréquence (5), divisant la fréquence du second signal d'horloge (4) par un facteur entier N₁ variable, et produisant un troisième signal d'horloge (6) dont la fréquence est variable de façon continue par modification du facteur N₁ et de la commande du second oscillateur.

## Description

### Domaine technique

La présente invention se rapporte au domaine des synthétiseurs de fréquence, et plus particulièrement aux synthétiseurs de fréquence destinés aux dispositifs à radiofréquences (RF).

### État de la technique

Les dispositifs émetteur et/ou récepteur à radiofréquences nécessitent des horloges RF (généralement de l'ordre du GHz), et ayant une grande pureté spectrale (c'est-à-dire dont la composante à la fréquence centrale du spectre a une amplitude très supérieure aux autres composantes du spectre). La fréquence de ces horloges doit également pouvoir être ajustée facilement, afin de couvrir la bande de fréquence visée. Des normes prévoient généralement l'allocation de bandes de fréquences, et ces bandes de fréquences peuvent être divisées en une pluralité de canaux consécutifs. Il faut donc être capable de produire une horloge dont la fréquence peut couvrir chaque canal de la bande de fréquence.

Généralement, les synthétiseurs de fréquence destinés à générer ces horloges RF sont basés sur l'utilisation d'une horloge de référence, de fréquence très inférieure à la fréquence de l'horloge RF à obtenir. Une PLL (de l'anglais Phase-Locked Loop, pour boucle à verrouillage de phase) est ensuite utilisée afin de multiplier la fréquence de l'horloge de référence pour atteindre la fréquence voulue. L'utilisation, dans la boucle de la PLL, d'un diviseur de fréquence fractionnaire permet d'obtenir une horloge RF dont la fréquence est un multiple non-entier de la fréquence de l'horloge de référence, permettant ainsi un ajustement très fin de la fréquence de l'horloge RF. L'horloge RF peut-être obtenue au moyen d'un circuit résonant LC, et dont la capacité serait variable afin d'augmenter la plage de fréquences atteignables. La pureté spectrale de l'horloge obtenue avec un tel synthétiseur peut toutefois s'avérer insuffisante, particulièrement si l'inductance du circuit LC est réalisée sur circuit intégré ou alors nécessiter une consommation très importante, ce qui pénalise l'autonomie du système utilisant ce type de synthétiseur.

Des oscillateurs basés sur un élément résonant électromécanique à haute fréquence tel qu'un BAW (Bulk Acoustic Wave) permettent d'obtenir une pureté spectrale fortement améliorée par rapport à l'oscillateur LC (de l'ordre de 30 dB de gain à puissance égale). Un élément capacitif variable permet de modifier la fréquence de l'horloge produite par un tel oscillateur, mais la plage de variation de cette fréquence n'est pas aussi étendue que celle d'un oscillateur LC avec une capacité variable, et ne permet généralement pas de couvrir une bande de fréquence de largeur suffisante. Ainsi, de tels oscillateurs sont utilisés de préférence pour générer des signaux d'horloge à une fréquence RF fixe, le vieillissement et la dépendance de la fréquence à la température pouvant être compensés par l'utilisation d'une référence plus stable, telle qu'un quartz.

Afin d'améliorer l'étendue de la plage de variation de la fréquence de l'horloge produite par un BAW, il est possible de diviser la fréquence obtenue par l'oscillateur BAW, par une division fractionnaire, afin d'obtenir un signal IF (Intermediate Frequency), dont la fréquence est variable par modification du facteur de division. Cette horloge IF est ensuite mélangée à l'horloge RF issue de l'oscillateur BAW afin d'obtenir une horloge RF de fréquence variable. Cette solution n'est pas satisfaisante, car la division fractionnaire introduit un bruit de phase important sur l'horloge IF. Il en résulte, après mélange, que le bruit de phase sur l'horloge RF de fréquence variable est du même ordre de grandeur ou même supérieur à celui atteignable avec un oscillateur LC. L'avantage de la pureté spectrale de l'oscillateur BAW est ainsi perdu.

La présente invention propose un synthétiseur de fréquence permettant d'obtenir un signal d'horloge de fréquence variable et à haute pureté spectrale tout en évitant les inconvénients ci-dessus.

### Divulgation de l'invention

La présente invention concerne un synthétiseur de fréquence tel que décrit dans les revendications de la présente demande.

### Brève description des dessins

D'autres caractéristiques de la présente invention apparaîtront plus clairement à la lecture de la description qui va suivre, faite en référence au dessin annexé, dans lequel :
- la figure 1 représente un synthétiseur de fréquence selon une première variante de la présente invention,
- la figure 2 représente un synthétiseur de fréquence selon une seconde variante de la présente invention,
- la figure 3 représente un dispositif à radiofréquences utilisant l'un des synthétiseurs de fréquence selon la présente invention.

### Modes de réalisation de l'invention

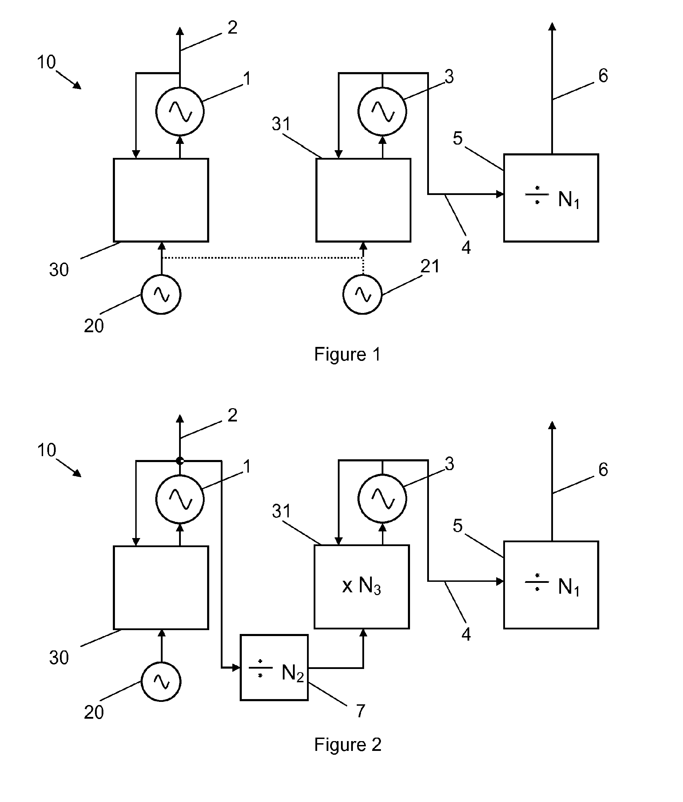

Une première variante d'un synthétiseur de fréquence est présentée en figure 1, le synthétiseur de fréquence 10 comprenant :
- un premier oscillateur commandé 1 par un premier dispositif d'asservissement, le premier oscillateur commandé présentant un facteur de qualité élevé, typiquement supérieur à 300 et produisant un premier signal d'horloge 2 RF de fréquence fixe,
- le premier dispositif d'asservissement 30 asservissant la fréquence du premier oscillateur commandé 1 à partir d'une première fréquence de référence,
- un second oscillateur commandé 3 par un second dispositif d'asservissement, et produisant un second signal d'horloge 4,
- le second dispositif d'asservissement 31 asservissant la fréquence du second oscillateur commandé 3 à partir d'une seconde fréquence de référence, et
- un diviseur entier de fréquence 5, divisant la fréquence du second signal d'horloge 4 par un facteur entier N₁ variable, et produisant un troisième signal d'horloge 6 dont la fréquence est variable de façon continue par modification du facteur N₁ et de la commande du second oscillateur.

La pureté spectrale d'un oscillateur est liée au facteur de qualité Q du résonateur utilisé. Plus le facteur Q est élevé, plus la pureté spectrale du signal d'horloge produit par l'oscillateur est grande. Le facteur de qualité Q est défini par le rapport entre l'énergie stockée dans le résonateur et celle qui y est dissipée par cycle.

L'ensemble constitué du premier oscillateur commandé et du second dispositif d'asservissement 30 est classiquement une PLL, dont l'entrée est une première fréquence de référence produite par un troisième oscillateur fixe 20.

Pour obtenir un facteur de qualité supérieur à 300, le premier oscillateur commandé 1 est basé sur un élément résonant électromécanique à haute fréquence tel qu'un BAW (Bulk Acoustic Wave). Un oscillateur de type SAW (Surface Acoustic Wave) est également adapté.

L'ensemble constitué du second oscillateur commandé 3 et du second dispositif d'asservissement 31 est également classiquement une PLL, dont l'entrée est une seconde fréquence de référence produite par un quatrième oscillateur fixe 21. Selon une variante, la seconde fréquence de référence peut être le même signal que la première fréquence de référence, donc produite également par le troisième oscillateur fixe 20. L'oscillateur commandé 3 est classiquement un VCO (Voltage-Controlled Oscillator), de type LC, dont la commande est assurée en modifiant la capacité du circuit LC.

L'utilisation d'un diviseur de fréquence 5 ayant un facteur de division N₁ entier permet de réduire de manière importante le bruit de phase du troisième signal d'horloge 6, le bruit de phase étant réduit d'un rapport qui est le carré du facteur de division. Par exemple, une division avec un facteur de N₁=30 permet de diminuer le bruit de phase de 30 dB. De plus, avec un facteur N₁ variable, on étend la plage de réglage de fréquence du troisième signal d'horloge 6 malgré une plage de variation limitée du second signal d'horloge 4.

La fréquence de l'oscillateur 3 et le facteur de division du diviseur entier de fréquence 5 sont déterminées de telle sorte que le bruit de phase du troisième signal d'horloge 6 soit équivalent à celui du premier oscillateur 1.

Les puretés spectrales des signaux d'horloge 2 et 6 sont alors du même ordre de grandeur et ces signaux d'horloge peuvent ensuite avantageusement être mélangés, de telle sorte que la dégradation, due aux bruits respectifs des signaux mélangés, soit réduite, typiquement à 3 dB environ. Ainsi, un tel synthétiseur permet de produire une porteuse RF dont la fréquence est variable et dont la pureté spectrale est très élevée.

Une seconde variante est présentée en référence à la figure 2, dans laquelle la seconde fréquence de référence est issue d'un diviseur fractionnaire de fréquence 7, dont l'entrée est le premier signal d'horloge 2 et divisant sa fréquence par un facteur fractionnaire N₂ variable.

En outre, le second moyen d'asservissement 31 multiplie la seconde fréquence de référence par un facteur N₃ entier pour produire le second signal d'horloge 4.

Les autres éléments sont les mêmes que ceux représentés sur la figure 1 et portent les mêmes références.

Cette variante présente les mêmes avantages que la première variante. En outre, le premier oscillateur commandé 1 est utilisé d'une part pour générer le premier signal d'horloge 2, mais également pour produire via le diviseur fractionnaire 7, la seconde fréquence de référence destinée à asservir la fréquence du second oscillateur commandé 3 à l'aide du second dispositif d'asservissement 31. Le rôle de ce dispositif d'asservissement 31 est de supprimer le bruit de phase introduit par le diviseur fractionnaire 7, à large écart de fréquence de la porteuse, et de permettre de produire, à l'aide du diviseur fractionnaire 5, un rapport de fréquence de (1/N₂)*(N₃/N₁) entre le premier signal d'horloge 2 et le troisième signal d'horloge 6. En minimisant les valeurs de N₂ et N₃, on obtient la meilleure performance de bruit, ce qui permet d'augmenter le bande passante de l'ensemble constitué de l'oscillateur commandé 3 et du dispositif d'asservissement 31. de plus, en changeant dynamiquement la valeur de N₂, une modulation de phase peut être effectuée sur le troisième signal d'horloge 6, à condition que la fréquence de modulation reste dans la bande passante du second dispositif d'asservissement 31. Selon cette variante, la première fréquence de référence peut avantageusement être obtenue au moyen d'un quartz de fréquence faible, par exemple 32 kHz, ce qui est particulièrement intéressant du point de vue de la consommation lorsque le synthétiseur de fréquence fonctionne en mode intermittent et du point de vue du nombre de composants externes requis qui se limite à ce même quartz.

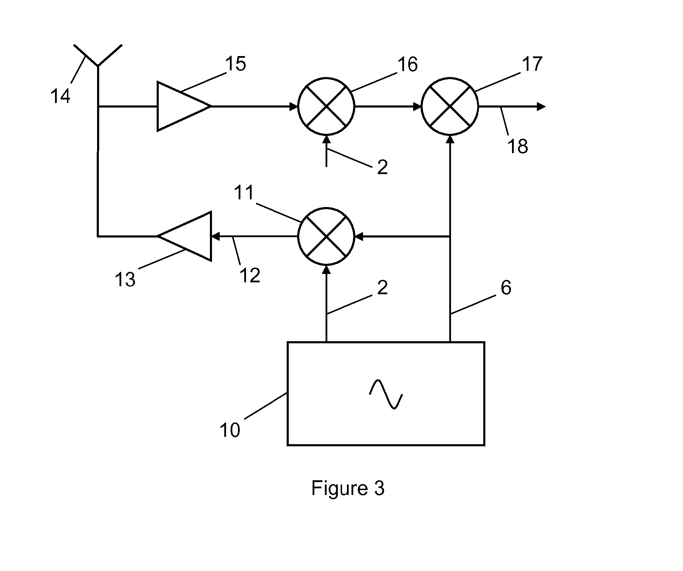

Le synthétiseur de fréquence 10 selon la première ou la seconde variante peut être utilisé dans un dispositif à radiofréquences en relation avec la figure 3. Outre le synthétiseur de fréquence 10, générant un premier signal d'horloge 2, de type RF et de fréquence fixe et un troisième signal d'horloge 6, dont la fréquence est variable, le dispositif radiofréquences comprend :
- un premier mélangeur 11, mélangeant les premier 2 et troisième 6 signaux d'horloge, pour produire une porteuse RF 12,
- un amplificateur RF 13, dont l'entrée est connectée à la porteuse RF 12,
- une antenne 14, émettant le signal de sortie de l'amplificateur RF 13, et recevant un signal en réception,
- un récepteur RF 15, dont l'entrée est connectée à l'antenne 14,
- un second mélangeur 16, mélangeant le signal de sortie du récepteur 15 et le premier signal d'horloge 2, et
- un troisième mélangeur 17, mélangeant le signal de sortie du second mélangeur 16 et le troisième signal d'horloge 6, produisant un signal correspondant à la transposition en bande de base ou à faible fréquence intermédiaire (low-IF) du signal reçu sur l'antenne 14.

La modulation de fréquence introduite grâce au facteur N₂ variable permet très facilement d'obtenir une porteuse RF 12 modulée en fréquence et ayant une grande pureté spectrale de façon à introduire les données à transmettre.

Un diviseur fixe de fréquence divisant la fréquence par 2 peut également être intercalé entre d'une part le troisième signal d'horloge 6 et d'autre part les premier 11 et troisième 17 mélangeurs, afin de générer des signaux en quadrature. Cette configuration permet d'implémenter, pour les mélangeurs 11, 16 et 17, des mélangeurs à réjection d'image.

Bien entendu, la présente invention est susceptible de diverses variantes et modifications qui apparaîtront évidentes à l'homme du métier.

## Revendications

1. Synthétiseur de fréquence comprenant :
- un premier oscillateur commandé (1) par un premier dispositif d'asservissement, le premier oscillateur présentant un facteur de qualité élevé, supérieur à 300 et produisant un premier signal d'horloge (2) RF de fréquence fixe,
- le premier dispositif d'asservissement (30), asservissant la fréquence du premier oscillateur commandé (1) à partir d'une première fréquence de référence,
- un second oscillateur commandé (3) par un second dispositif d'asservissement, et produisant un second signal d'horloge (4),
- le second dispositif d'asservissement (31), asservissant la fréquence du second oscillateur commandé (3) à partir d'une seconde fréquence de référence, et
- un diviseur entier de fréquence (5), divisant la fréquence du second signal d'horloge (4) par un facteur entier N₁ variable, et produisant un troisième signal d'horloge (6) dont la fréquence est variable de façon continue par modification du facteur N₁ et de la commande du second oscillateur.

2. Synthétiseur de fréquence selon la revendication 1, **caractérisé en ce que** la première fréquence de référence est produite par un troisième oscillateur fixe (20) et **en ce que** la seconde fréquence de référence est produite par un quatrième oscillateur fixe (21).

3. Synthétiseur de fréquence selon la revendication 1, **caractérisé en ce que** la première et la seconde fréquences de référence sont identiques et produites par un troisième oscillateur fixe (20).

4. Synthétiseur de fréquence selon les revendications 1 à 3, **caractérisé en ce que** le premier oscillateur commandé (1) comprend un résonateur de type BAW ou SAW.

5. Synthétiseur de fréquence selon les revendications 1 à 4, **caractérisé en ce que** le second oscillateur commandé (3) est un oscillateur LC.

6. Synthétiseur de fréquence selon les revendications 1 à 5, **caractérisé en ce qu'**il comprend en outre un diviseur fractionnaire de fréquence (7), dont l'entrée est le premier signal d'horloge (2) et divisant sa fréquence par un facteur fractionnaire N₂ variable, produisant la seconde fréquence de référence et **caractérisé en ce que** le second dispositif d'asservissement (31) multiplie la fréquence de la seconde fréquence de référence par un facteur N₃, pour produire le second signal d'horloge (4).

7. Dispositif à radiofréquences comprenant :
- le synthétiseur de fréquence selon l'une des revendications 1 à 6,
- un premier mélangeur (11), destiné à mélanger les premier (2) et troisième (6) signaux d'horloge pour produire une porteuse RF (12),
- un amplificateur RF (13), dont l'entrée est connectée à la porteuse RF (12),
- une antenne (14), destinée à émettre le signal de sortie de l'amplificateur RF (13), et à recevoir un signal en réception,
- un récepteur RF (15), dont l'entrée est connectée à l'antenne (14),
- un second mélangeur (16), destiné à mélanger le signal de sortie du récepteur (15) et le premier signal d'horloge (2), et
- un troisième mélangeur (17), destiné à mélanger le signal de sortie du second mélangeur (16) et le troisième signal d'horloge (6), pour produire un signal correspondant à la transposition en bande de base ou à faible fréquence intermédiaire (low-IF) du signal reçu sur l'antenne (14).

8. Dispositif à radiofréquences selon la revendication 7, **caractérisé en ce qu'**il comprend en outre un diviseur fixe de fréquence, destiné à diviser la fréquence par 2, intercalé entre d'une part le troisième signal d'horloge (6) et d'autre part les premier (11) et troisième (17) mélangeurs.

9. Dispositif à radiofréquences selon la revendication 8, **caractérisé en ce que** les mélangeurs (11, 16, 17) sont des mélangeurs à réjection d'image.
